# DEMANDE DE BREVET EUROPEEN

(11) **EP 0 831 408 A1**
(43) Date de publication de la demande: **25.03.1998**
(21) Numéro de dépôt: 97402038.0
(22) Date de dépôt: 02.09.1997
(51) Int. Cl.: G06F 17/50

(54) **Procédé de développement d'un circuit intégré spécifique d'une application (ASIC) et émulateur correspondant**

(30) Priorité: 03.09.1996 FR 9610716
(71) Demandeur: Info technologies, 94588 Rungis Cedex (FR)
(72) Inventeur: Chieppa, Jean Marie, 91300 Massy (FR)
(74) Mandataire: Casalonga, Axel

(57) **Abrégé**

On utilise pour le développement et la mise au point de l'ASIC, une bibliothèque de composants réalisables sous forme de circuits intégrés à partir de blocs-durs (300), et un émulateur système temps réel que l'on configure (302) dans l'application spécifique choisie. Le processus de fabrication de l'ASIC prévoit la réalisation des composants périphériques reliés au microprocesseur à partir des mêmes blocs-durs que ceux ayant servi à l'élaboration des composants périphériques de l'émulateur.

## Description

L'invention concerne le développement des circuits intégrés spécifiques d'une application (ASIC : "Application specific integrated circuit" en langue anglaise).

Les progrès enregistrés dans la technologie de fabrication des circuits intégrés se sont concrétisés par l'avènement des circuits dits VLSI c'est-à-dire à très haute densité d'intégration. La forte croissance continue de la complexité des circuits et une diversification des fonctions qu'ils réalisent, nécessitent des durées de conception par circuit pouvant aller jusqu'à des dizaines d'hommes/années. D'autre part, même l'arrivée des ASIC sur le marché n'a pas permis, à ce jour, d'apporter de solutions efficaces dès qu'il s'agissait d'intégrer des coeurs de logiques microprogrammées.

Actuellement, lorsque l'on souhaite mettre au point et développer une carte électronique comprenant un ASIC comportant lui-même un coeur de microprocesseur et des composants périphériques reliés au microprocesseur, on dispose de moyens limités pour vérifier le bon fonctionnement de la carte et de l'ASIC. Plus précisément, on dispose d'outils de simulation sur ordinateur mais qui ne permettent ni de vérifier le fonctionnement de l'ASIC au sein de la carte système, ni de vérifier à fortiori le bon fonctionnement du logiciel applicatif associé.

De même, certains outils d'usage universel permettent d'émuler de façon matérielle un ASIC, mais ils sont limités en vitesse d'exécution, ne représentent qu'imparfaitement l'ASIC final, en particulier du point de vue structurel, et ne permettent pas d'émuler des fonctions analogiques.

En fait, aucun outil ne permet à ce jour de vérifier le bon fonctionnement temps réel de l'ASIC et de la carte système et de développer simultanément l'ASIC, la carte système et le logiciel applicatif.

L'invention vise à apporter une solution à ce problème.

Le principe de l'invention repose sur le fait de pouvoir intégrer toutes les fonctions, en particulier de logiques microprogrammées, de logiques câblées et analogiques, dans un circuit intégré tout en donnant à l'ingénieur système chargé de la conception et de la mise au point de l'ASIC final, les moyens lui permettant:
- d'élaborer l'architecture matérielle de l'ASIC final,
- de disposer d'un outil de développement pour valider l'architecture qu'il aura obtenu et de développer "en toute sécurité" la partie logicielle de son application.

Pour cela, l'invention prévoit les moyens suivants :
- une bibliothèque de composants, réalisables sous forme de circuits intégrés, possédant chacun un identifiant pouvant être lu directement au moyen d'un bus, et accompagnée d'une spécification détaillée pour chacun des composants, et
- un émulateur temps réel, configurable, et architecturé autour d'un coeur de microprocesseur relié à un bus numérique synchrone du type microprocesseur, c'est-à-dire un bus synchrone véhiculant des données et des adresses selon un protocole d'échange d'informations numériques prédéfini.

A partir du cahier des charges, préalablement établi, l'ingénieur système pourra alors bâtir l'architecture de l'ASIC au moyen des spécifications de la bibliothèque de composants et établir le schéma électrique.

Il pourra d'autre part enficher sur l'émulateur les composants physiques réalisés sous forme de circuits intégrés qu'il aura préalablement sélectionnés dans la bibliothèque pour établir l'architecture de l'ASIC, et configurer l'émulateur de façon à rendre celui-ci conforme au schéma électrique de l'ASIC.

On disposera, à ce moment-là, d'un émulateur configuré directement dans l'application spécifique choisie, ce qui permettra de valider rapidement la conformité de la fonctionnalité de l'émulateur par rapport à son schéma électrique tout en développant et en mettant au point le logiciel d'application. L'implémentation silicium du circuit intégré final pourra alors être engagée automatiquement en réalisant notamment les composants périphériques reliés au microprocesseur à partir des mêmes spécifications détaillées que celles ayant servi à l'élaboration des composants périphériques de l'émulateur.

En outre, le fait d'utiliser un bus du type microprocesseur permettant d'établir une configuration d'adresses sur le bus pour les composants périphériques de l'émulateur, offre l'avantage de s'affranchir de l'utilisation d'une matrice de configuration sur l'émulateur réalisée généralement à partir de portes et de circuits logiques programmables. En effet, une telle matrice de configuration ne peut pas être réalisée sur l'émulateur directement sous la forme d'un ASIC, car elle doit pouvoir être programmée en fonction de chaque configuration désirée sur l'émulateur. Par conséquent, sa transposition sous forme d'un composant ASIC au sein de l'ASIC final est non seulement difficile mais peut occasionner des problèmes de fonctionnement temps réel de l'ASIC final.

L'invention évite cet inconvénient par l'utilisation d'un bus du type microprocesseur qui est facilement intégrable dans l'ASIC final et qui permet en outre de simuler correctement le fonctionnement temps réel de l'ASIC final.

Par ailleurs, dans le cas du développement et de la mise au point d'une carte système comportant l'ASIC relié à des composants externes à l'ASIC, l'invention permet de valider directement l'ensemble de la carte système avant la réalisation proprement dite de l'ASIC final, ce qui n'était pas possible dans l'art antérieur.

En d'autres termes, l'invention propose donc un procédé de développement d'un circuit intégré spécifique d'une application (ASIC), ce circuit comportant au moins un microprocesseur d'un type prédéterminé et plusieurs composants périphériques reliés au microprocesseur par un bus de liaison spécifique synchrone, c'est-à-dire un bus synchrone de type microprocesseur. Selon une caractéristique générale de l'invention, on réalise un émulateur comportant un bus-image de type microprocesseur, synchrone et compatible avec le bus de liaison spécifique. On relie à ce bus-image, au moins un coeur éclaté de microprocesseur-image compatible avec le microprocesseur de l'ASIC, un bloc-mémoire associé contenant au moins des moyens de contrôle du coeur de microprocesseur-image, et une interface avec un outil de développement d'un logiciel applicatif correspondant à ladite application. On élabore plusieurs blocs-durs ("hard blocks" en langue anglaise) de circuits intégrés à partir desquels on réalise respectivement des circuits intégrés élémentaires périphériques respectivement fonctionnellement identiques auxdits composants périphériques de l'ASIC. Chacun de ces circuits intégrés élémentaires est identifiable, connectable sur le bus-image et apte à fonctionner en mode synchrone et testable selon un mode de test prédéterminé. On connecte sur le bus-image lesdits circuits intégrés élémentaires. On établit, à partir de l'identifiant de chaque circuit intégré élémentaire, une configuration d'adresses de ces circuits intégrés élémentaires sur le bus-image, et on interconnecte en outre mutuellement les différents circuits intégrés élémentaires selon une configuration de test compatible avec ledit mode de test prédéterminé. On réalise le circuit intégré spécifique, après l'avoir mis au point à l'aide de l'émulateur et de l'outil de développement, en réalisant les différents composants périphériques à partir desdits blocs-durs et en les agençant selon les mêmes configurations d'adresses et de test que celles utilisées sur l'émulateur.

L'invention propose également un dispositif d'émulation pour un circuit intégré spécifique d'une application, ledit circuit comportant au moins un microprocesseur d'un type prédéterminé et plusieurs composants périphériques reliés au microprocesseur par un bus de liaison spécifique synchrone. Ce dispositif d'émulation comprend:
- des circuits intégrés élémentaires périphériques respectivement fonctionnellement identiques auxdits composants périphériques, chacun de ces circuits intégrés élémentaires comportant un moyen de mémoire contenant un identifiant dudit circuit intégré élémentaire et du bloc-dur ayant permis sa réalisation, et une interface de connexion sur un bus-image de type microprocesseur synchrone et compatible avec ledit bus de liaison spécifique. Chaque circuit intégré élémentaire est en outre apte à fonctionner en mode synchrone et à être testé selon un mode de test prédéterminé,
- un émulateur comportant ledit bus-image, et, reliés à ce bus-image, au moins un coeur éclaté de microprocesseur-image compatible avec le microprocesseur du circuit intégré spécifique, un bloc-mémoire associé contenant au moins des moyens de contrôle du coeur de microprocesseur-image, une interface avec un outil de développement d'un logiciel applicatif correspondant à ladite application, et des supports élémentaires aptes à coopérer avec les interfaces de connexion des circuits intégrés élémentaires. Il est également prévu dans cet émulateur des moyens commandables d'interconnexion mutuelle des différents supports élémentaires. Les moyens de contrôle du coeur de microprocesseur sont aptes à adresser les différents supports de façon à établir une configuration d'adresses des différents circuits intégrés élémentaires sur le bus-image, et à commander les moyens d'interconnexion de façon à établir une configuration de test des circuits intégrés élémentaires compatible avec ledit mode de test prédéterminé.

De façon notamment à ce que l'émulateur puisse être configurable, c'est-à-dire puisse être utilisé pour différentes applications, l'émulateur comporte avantageusement un nombre de supports élémentaires supérieurs au nombre de circuits intégrés élémentaires connectés sur le bus-image.

Les moyens d'interconnexion comportent par exemple un circuit commandable de commutation relié aux supports élémentaires par un câblage spécifique, par exemple un bus série.

Par ailleurs, le coeur de microprocesseur peut comporter un circuit de conversion de signaux. Ceci permet alors de pouvoir utiliser l'émulateur avec un coeur de microprocesseur ne correspondant pas directement aux spécificités du bus-image de l'émulateur.

Les circuits intégrés élémentaires peuvent comporter des fonctions logiques ou analogiques.

Enfin, lorsque le circuit intégré spécifique est destiné à être relié à des composants externes (de façon à fournir une carte système plus complexe) par l'intermédiaire d'un port d'entrée/sortie et/ou par l'intermédiaire des entrées/sorties des composants périphériques de l'ASIC, l'émulateur comporte alors avantageusement également une interface d'entrée/sortie reliée sur le bus-image, et apte à coopérer avec le port d'entrée/sortie. Les circuits intégrés périphériques de l'émulateur peuvent également être reliés par un câblage spécifique directement aux composants externes de la carte système.

D'autres avantages et caractéristiques de l'invention apparaîtront à l'examen d'un mode de réalisation et de mise en oeuvre, nullement limitatifs, et des dessins annexés sur lesquels :
la figure 1 est un synoptique schématique d'une carte électronique comportant un ASIC que l'on souhaite mettre au point et développer,
- la figure 2 est une synoptique schématique d'un émulateur selon l'invention; et
- la figure 3 est un organigramme schématique d'un mode de mise en oeuvre du procédé selon l'invention.

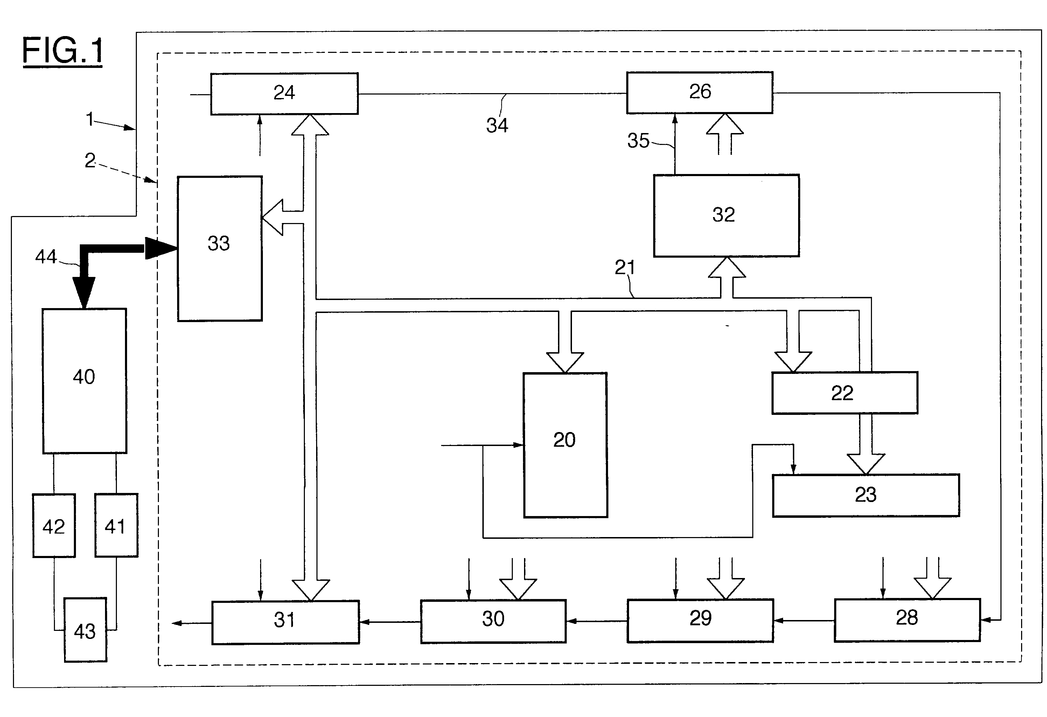

Telle qu'illustrée sur la figure 1, la carte électronique 1 (carte système) destinée à être développée pour une application particulière, comporte un circuit intégré 2 spécifique de ladite application (ASIC) relié par l'intermédiaire d'un port d'entrée/sortie 33 et d'une liaison spécifique 44 à une interface externe 40 sur laquelle sont connectés des composants externes 41, 42 et 43.

D'un point de vue structurel, l'ASIC que l'on souhaite réaliser se compose d'un coeur de microprocesseur 20, par exemple un microprocesseur du type 68 HC11 de la Société MOTOROLA, associé à une mémoire vive 22 et une mémoire morte 23 dans laquelle sera notamment stocké le logiciel applicatif. Ce coeur de microprocesseur est relié aux mémoires 22 et 23 par l'intermédiaire d'un bus de liaison synchrone 21 spécifique au fonctionnement du microprocesseur choisi. Sur ce bus de type microprocesseur sont également connectés des composants périphériques 24, 26 et 28-31. Ces composants périphériques peuvent comporter des fonctions logiques ou analogiques, par exemple des convertisseurs analogiques/numériques ou numériques/analogiques, des oscillateurs, des amplificateurs opérationnels.

Ces divers composants périphériques sont adressés sur le bus 21 par l'intermédiaire d'un décodeur classique d'adresse 32 et de "fils" d'adresses 35. On verra ci-après que cette configuration d'adresse résulte en fait de celle utilisée sur l'émulateur.

En outre, les divers composants sont interconnectés par une liaison spécifique de test 34, par exemple un bus série, de façon à pouvoir être testés. De même, cette interconnexion spécifique de test résulte de celle utilisée sur l'émulateur.

Enfin, ces composants périphériques peuvent être également reliés directement au port d'entrée/sortie 33.

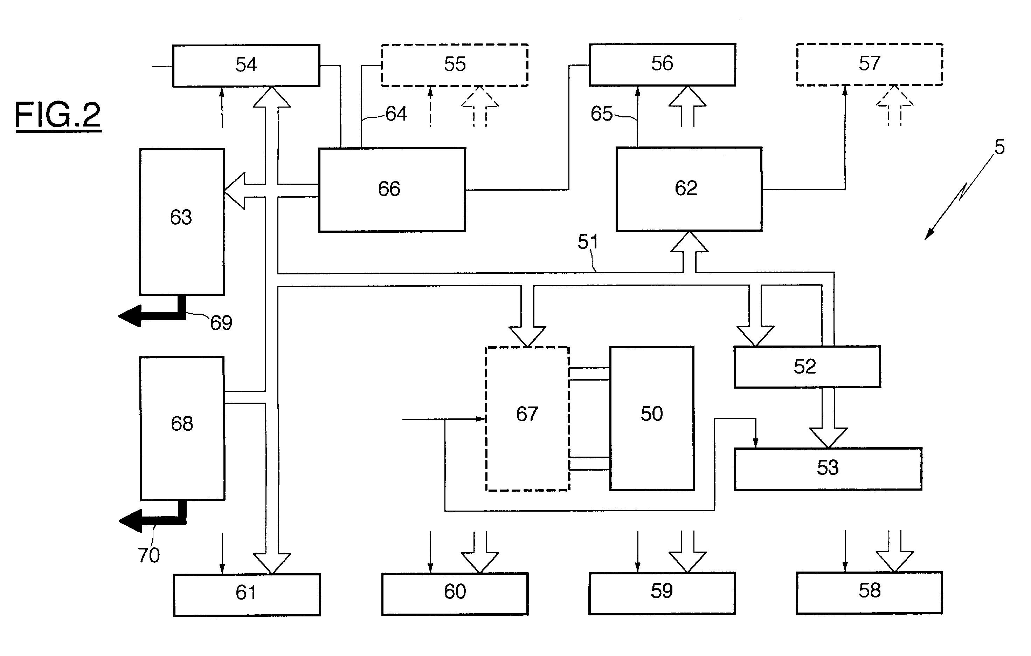

Tel qu'illustré sur la figure 2, l'émulateur 5 selon l'invention comporte un coeur 50 de microprocesseur compatible avec le coeur de microprocesseur de l'ASIC 2, en l'espèce également un coeur de microprocesseur 68 HC11. Ce coeur de microprocesseur est réalisé sous forme de circuit intégré sur l'émulateur, de façon classique à partir d'un bloc dur c'est-à-dire un schéma électrique d'interconnexion et de spécification permettant de façon classique l'élaboration du circuit intégré.

L'émulateur 5 comporte également un bus-image de type microprocesseur 51 compatible avec le bus de liaison spécifique 21 de l'ASIC. Ce bus est synchrone, et d'une façon générale, l'émulateur fonctionne en mode synchrone. On rappelle ici qu'un bus synchrone, par opposition à un bus asynchrone qui fonctionne sans signal d'horloge, possède une horloge commune pour tous les éléments connectés sur le bus. Et tous les évènements, tels que les changements d'états, dans ces éléments sont synchronisés par l'horloge du bus. En l'espèce, le bus-image 51 sera également un bus de liaison directement utilisable avec un microprocesseur 68 HC11.

Une mémoire vive 52 et une mémoire morte 53, associées au coeur de microprocesseur 50 sont également reliées sur le bus-image.

Une interface 63 d'entrée/sortie, connectée sur le bus-image 51 est apte à être reliée, pour l'émulation, par une liaison spécifique 69 (sonde) à l'interface externe 40 reliée aux composants externes 41-43 de la carte.

Par ailleurs, il est également prévu une interface 68 reliée sur le bus-image 51, destinée à être reliée par une liaison spécifique 70, par exemple une liaison série RS 232, à un outil de développement, par exemple un micro-ordinateur, (non représenté ici à des fins de simplification), permettant le développement et la mise au point du logiciel applicatif de l'ASIC.

L'émulateur comporte également une pluralité, en pratique une cinquantaine, de supports élémentaires 54-61 comportant des broches de connexion et capables chacun de recevoir un circuit intégré élémentaire périphérique dont on reviendra plus en détail ci-après sur la structure et la fonction. Chaque support possède une adresse sur le bus-image 51 et est adressable via un décodeur d'adresse 62 associé à un câblage spécifique 65.

Seuls certains des supports sont utilisés sur l'émulateur en fonction du nombre de composants périphériques de l'ASIC que l'on souhaite émuler et réaliser. En l'espèce, puisque six composants périphériques 24-31 sont prévus sur l'ASIC 2, seuls six supports 54, 56 et 58-61 seront utilisés pour recevoir six circuits intégrés élémentaires. Les autres supports 55 et 57, illustrés en tiretés sur la figure 2 ne seront pas utilisés dans cette application. Les entrées/sorties de certains au moins des circuits intégrés périphériques pourront également être directement reliées à l'interface 63.

Un élément essentiel de l'invention réside dans un fichier ou bibliothèque de composants périphériques. Ce fichier comporte pour chacun des ces composants un bloc-dur de circuit intégré à partir duquel on pourra réaliser le circuit intégré élémentaire correspondant. Chaque bloc dur comporte un identifiant, par exemple un numéro de version et un numéro de type, permettant d'identifier très précisément le bloc-dur utilisé et par conséquent le circuit intégré élémentaire correspondant.

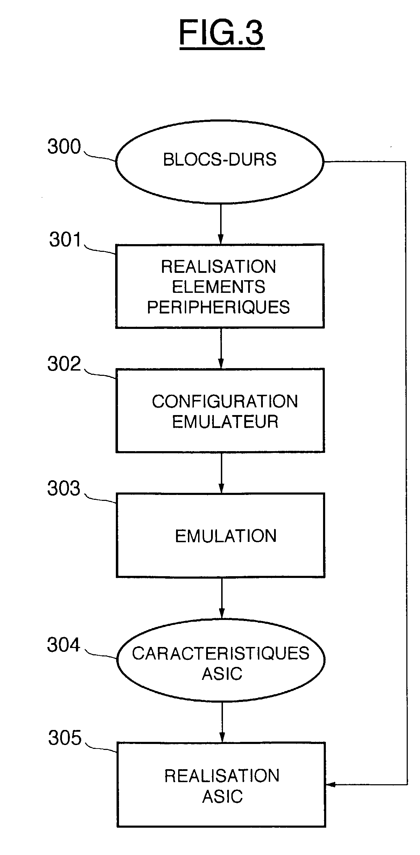

Ainsi, après avoir identifié les fonctions périphériques qui vont être implantées sur l'ASIC final 2, on sélectionne les blocs durs correspondant 300 (figure 3) et l'on réalise à partir de ces blocs durs (étape 301) les éléments périphériques correspondants sous forme de circuits intégrés. Chacun de ces circuits intégrés élémentaires comporte un moyen de mémoire, par exemple un registre, contenant l'identifiant dudit circuit intégré élémentaire et du bloc dur ayant permis sa réalisation, ainsi qu'une interface de connexion sur le bus-image. En outre, le bloc dur est classiquement conçu de façon à ce que le circuit intégré élémentaire réalisé correspondant puisse fonctionner en mode synchrone (à partir de la même horloge que celle utilisée par le bus et le microprocesseur), et puisse être testé selon un mode de test prédéterminé.

Chacun des circuits intégrés élémentaires ainsi réalisés est ensuite enfiché, généralement manuellement, dans un support de l'émulateur et des moyens de contrôle du coeur de microprocesseur de l'émulateur, logés dans la mémoire morte 53, déterminent par un balayage d'adresses des supports, via le décodeur d'adresse 62 associé au câblage spécifique 65, la localisation des circuits sur l'émulateur et établissent une configuration d'adresses des différents circuits intégrés élémentaires sur le bus-image 51, en l'espèce logés dans les supports 54, 56 et 58-61.

Cette configuration d'adresses est lisible directement par le logiciel du coeur de microprocesseur de l'émulateur grâce notamment à la présence des identifiants internes des circuits intégrés élémentaires, et s'effectue automatiquement quelles que soient les positions de ces derniers sur l'émulateur, c'est-à-dire quels que soient les supports choisis par l'utilisateur pour enficher les circuits intégrés élémentaires, sans qu'il soit nécessaire notamment d'effectuer un repérage additionnel externe des supports et/ou des circuits intégrés élémentaires effectivement choisis lors de l'enfichage de ces derniers.

Il est prévu sur l'émulateur des moyens 66, commandables également par les moyens de contrôle logés dans la mémoire morte 53, pour interconnecter mutuellement les différents supports élémentaires utilisés, et par conséquent les différents circuits intégrés élémentaires, selon une configuration de test compatible avec le mode de test prédéterminé prévu pour les circuits intégrés élémentaires.

Matériellement, ces moyens d'interconnexion 66, par exemple une "matrice de configuration de SCAN" qui permet la mise en oeuvre d'un mode particulier de test ("SCAN TEST") bien connu de l'homme du métier, peuvent être réalisés de façon classique à partir de portes logiques et de moyens de mutliplexage. On définit alors un câblage spécifique de test 64. Ce câblage est par exemple un bus-série tel que celui prévu par la norme IEEE Std 1149.1-1990.

Il est également possible, en variante, de lire la configuration d'adresses des différents circuits intégrés élémentaires sur le bus-image 51 en utilisant un moniteur spécifique externe à l'émulateur et relié au bus-série de test. En d'autres termes, on lit les identifiants des circuits intégrés élémentaires et on identifie les supports correspondants à partir du bus de test. La configuration effective d'adresses des circuits intégrés élémentaires sur le bus-image 51 est ensuite chargée dans le logiciel du coeur de micoroprocesseur de l'émulateur. Cette variante de mise en oeuvre permet d'utiliser un adressage normalisé, tel que celui défini par la norme IEEE 1149.1 précitée.

A ce stade, la configuration 302 de l'émulateur est terminée.

On peut alors procéder à l'émulation 303 en connectant l'interface 63 sur l'interface 40 de la carte électronique 1 et en utilisant l'outil de développement connecté sur l'interface 68 pour la mise au point du logiciel applicatif.

Lorsque cette émulation est terminée, le logiciel applicatif étant validé, on extrait alors (étape 304) les caractéristiques des l'ASIC c'est-à-dire la configuration (communément désignée sous le vocable "net list" en langue anglaise par l'homme du métier) comportant notamment les configurations d'adresses et de tests des différents éléments.

Ensuite, à partir de cette configuration et des blocs durs qui ont été utilisés pour la réalisation des circuits intégrés élémentaires et qui sont repérés par leur identifiant, on réalise le circuit intégré spécifique final 2 comportant le coeur de microprocesseur choisi, le bus de liaison spécifique et les différents composants périphériques 24, 26, 28 et 31 ayant la même configuration d'adresse et la même configuration de test que celle qui a été utilisée sur l'émulateur. Bien entendu, dans l'ASIC final, les moyens 66 (c'est-à-dire la matrice configurable) ne sont pas réalisés.

Comme cela a été évoqué ci-avant, le dispositif d'émulation selon l'invention a pour fonction de valider l'architecture de l'application spécifique et son logiciel, et de permettre de lancer le circuit intégré spécifique en fabrication. Ceci est notamment possible en raison du fait que l'émulateur présente, quelle que soit l'architecture de l'ASIC final retenu, une reproduction fidèle de ce que devra être l'architecture silicium finale.

C'est la raison pour laquelle il est important que l'émulateur comporte une partie configurable notamment un grand nombre de supports connectables sur le bus d'adresse et mutuellement interconnectables en mode de test. Afin d'augmenter encore les possibilités de configuration de l'émulateur, il est prévu d'associer au coeur de microprocesseur 50 un circuit classique 67 de conversion de signaux utilisable lorsque le bus-image 51 n'est pas directement utilisable par le coeur de microprocesseur 50. Dans ce cas , le circuit 67 permettra la conversion des signaux numériques circulant sur le bus 51 et ceux exploitables par le coeur de microprocesseur 50.

En variante, de façon à offrir à l'utilisateur un plus large éventail de possibilités, on peut prévoir d'utiliser tant pour l'ASIC final que pour l'émulateur un bus synchrone normalisé et aisément intégrable dans un ASIC, tel que le bus connu par l'homme du métier sous la dénomination PI-Bus et dont le protocole est défini dans la norme OMI 324 (OMI : Open Microprocesseur Systems Initiative).

## Revendications

1. Procédé de développement d'un circuit intégré spécifique d'une application, ledit circuit (2) comportant au moins un microprocesseur (20) d'un type prédéterminé et plusieurs composants périphériques (24-31) reliés au microprocesseur par un bus de liaison synchrone de type microprocesseur (21), caractérisé par le fait qu'on réalise un émulateur (5) comportant un bus-image de type microprocesseur (51), synchrone et compatible avec ledit bus de liaison (21), et reliés à ce bus-image, au moins un coeur éclaté de microprocesseur-image (50) compatible avec le microprocesseur du composant, un bloc-mémoire associé (53) contenant au moins des moyens de contrôle du coeur de microprocesseur-image, et une interface (68) avec un outil de développement d'un logiciel applicatif correspondant à ladite application, on élabore plusieurs blocs-durs (300) de circuits intégrés à partir desquels on réalise respectivement des circuits intégrés élémentaires périphériques (301) respectivement fonctionnellement identiques auxdits composants périphériques, chacun de ces circuits intégrés élémentaires étant identifiable, connectable sur le bus-image, apte à fonctionner en mode synchrone et testable selon un mode de test prédéterminé, on connecte sur le bus-image lesdits circuits intégrés élémentaires, on établit, à partir de l'identifiant de chaque circuit intégré élémentaire, une configuration d'adresses sur le bus-image de ces circuits intégrés élémentaires, et on interconnecte en outre mutuellement les différents circuits intégrés élémentaires selon une configuration de test compatible avec ledit mode de test prédéterminé, et on réalise (305) ledit circuit intégré spécifique, après l'avoir mis au point à l'aide de l'émulateur et de l'outil de développement, en réalisant les différents composants périphériques à partir desdits blocs-durs et en les agençant selon les mêmes configurations d'adresses et de test que celles utilisées sur l'émulateur.

2. Dispositif d'émulation pour un circuit intégré spécifique d'une application, ledit circuit (2) comportant au moins un microprocesseur (20) d'un type prédéterminé et plusieurs composants périphériques (24-31) reliés au microprocesseur par un bus de liaison synchrone de type microprocesseur, ledit dispositif comprenant:
- des circuits intégrés élémentaires périphériques respectivement fonctionnellement identiques auxdits composants périphériques, chacun de ces circuits intégrés élémentaires comportant un moyen de mémoire contenant un identifiant dudit circuit intégré élémentaire et du bloc-dur (300) ayant permis sa réalisation, une interface de connexion sur un bus-image de type microprocesseur, synchrone et compatible avec ledit bus de liaison, et étant aptes à fonctionner en mode synchrone et à être testés selon un mode de test prédéterminé,
- un émulateur (5) comportant ledit bus-image (21), et reliés à ce bus-image, au moins un coeur éclaté de microprocesseur-image (20) compatible avec le microprocesseur (50) du composant, un bloc-mémoire associé contenant au moins des moyens de contrôle du coeur de microprocesseur-image, une interface (68) avec un outil de développement d'un logiciel applicatif correspondant à ladite application, et des supports élémentaires (54-61) aptes à coopérer avec les interfaces de connexion des circuits intégrés élémentaires, des moyens commandables (66) d'interconnexion mutuelle des différents supports élémentaires, les moyens de contrôle du coeur de microprocesseur étant aptes à adresser les différents supports de façon à établir une configuration d'adresses des différents circuits intégrés élémentaires sur le bus-image, et à commander les moyens d'interconnexion de façon à établir une configuration de test des circuits intégrés élémentaires compatible avec ledit mode de test prédéterminé.

3. Dispositif selon la revendication 2, caractérisé par le fait que l'émulateur (5) comporte un nombre de supports élémentaires supérieur au nombre de circuits intégrés élémentaires connectés sur le bus-image.

4. Dispositif selon la revendication 2 ou 3, caractérisé par le fait que les moyens d'interconnexion (66) comportent un circuit commandable de commutation relié aux supports élémentaires par un

5. Dispositif selon l'une des revendications 2 à 4, caractérisé par le fait que le coeur de microprocesseur comporte un circuit de conversion de signaux (67).

6. Dispositif selon l'une des revendications 2 à 5, caractérisé par le fait que les circuits intégrés élémentaires comportent des fonctions logiques ou analogiques.

7. Dispositif selon l'une des revendications 2 à 6, pour l'émulation d'un circuit intégré spécifique destiné à être relié à des composants externes par l'intermédiaire d'un port d'entrée/sortie (40), caractérisé par le fait que l'émulateur comporte une interface d'entrée/sortie (63), reliée sur le bus-image, apte à coopérer avec le port d'entrée/sortie (40).
